(19) Europäisches Patentamt / European Patent Office / Office européen des brevets

(11) **EP 2 397 440 B1**

(12) **EUROPEAN PATENT SPECIFICATION**

(45) Date of publication and mention
of the grant of the patent:
**20.11.2019   Bulletin 2019/47**

(21) Application number: **10741066.4**

(22) Date of filing: **08.02.2010**

(51) Int Cl.:
**B82Y 30/00** (2011.01)      **B82Y 40/00** (2011.01)
**C01B 32/158** (2017.01)      **C01B 32/162** (2017.01)
**C23C 16/455** (2006.01)      **C23C 16/46** (2006.01)
**C01B 32/16** (2017.01)

(86) International application number:
**PCT/JP2010/000742**

(87) International publication number:
**WO 2010/092786 (19.08.2010 Gazette 2010/33)**

(54) **SUBSTRATE FOR PRODUCING ALIGNED CARBON NANOTUBE AGGREGATES AND METHOD FOR PRODUCING THE ALIGNED CARBON NANOTUBE AGGREGATES**

SUBSTRAT ZUR HERSTELLUNG AUSGERICHTETER KOHLENSTOFFNANORÖHRCHENAGGREGATE SOWIE VERFAHREN ZUR HERSTELLUNG AUSGERICHTETER KOHLENSTOFFNANORÖHRCHENAGGREGATE

SUBSTRAT POUR PRODUIRE DES AGREGATS DE NANOTUBES DE CARBONE ALIGNES ET PROCEDE DE PRODUCTION DES AGREGATS DE NANOTUBES DE CARBONE ALIGNES

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **10.02.2009   JP 2009029127**

(43) Date of publication of application:
**21.12.2011   Bulletin 2011/51**

(73) Proprietors:
• **Zeon Corporation**
  **Tokyo 100-8246 (JP)**
• **National Institute of Advanced Industrial Science and Technology**
  **Tokyo 100-8921 (JP)**

(72) Inventors:
• **TAKAI, Hirokazu**
  **Tokyo 100-8246 (JP)**
• **HATA, Kenji**
  **Tsukuba-shi**
  **Ibaraki 305-8565 (JP)**
• **YUMURA, Motoo**
  **Tsukuba-shi**
  **Ibaraki 305-8565 (JP)**

(74) Representative: **Maiwald Patent- und Rechtsanwaltsgesellschaft mbH**
**Elisenhof**
**Elisenstraße 3**
**80335 München (DE)**

(56) References cited:
JP-A- 2004 051 432      JP-A- 2004 068 187
JP-A- 2006 036 593      US-A1- 2005 092 464
US-A1- 2008 131 655

• DATABASE WPI Week 200972 Thomson Scientific, London, GB; AN 2009-Q23443 XP002738899, & WO 2009/128349 A1 (DOKURITSU GYOSEI HOJIN SANGYO GIJUTSU SO) 22 October 2009 (2009-10-22) & EP 2 263 974 A1 (ZEON CORP [JP]; NAT INST OF ADVANCED IND SCIEN [JP]) 22 December 2010 (2010-12-22)
• DATABASE WPI Week 201107 Thomson Scientific, London, GB; AN 2011-A54229 XP002738900, & WO 2011/001969 A1 (DOKURITSU GYOSEI HOJIN SANGYO GIJUTSU SO) 6 January 2011 (2011-01-06) & EP 2 450 310 A1 (ZEON CORP [JP]; NAT INST OF ADVANCED IND SCIEN [JP]) 9 May 2012 (2012-05-09)

## Description

Technical Field

The present invention relates to a substrate for producing aligned carbon nanotube aggregates and a method for producing the aligned carbon nanotube aggregates. Specifically, the present invention relates to a substrate or the like for producing the aligned carbon nanotube aggregates which substrate is less bent and/or less deformed particularly by preventing the substrate from being carburized, and which contributes to improvement in productivity of the aligned carbon nanotube aggregates by repetitive use of the substrate.

Background Art

Carbon nanotubes (hereinafter referred to also as "CNTs") are carbon structures each structured such that a carbon sheet composed of carbon atoms arranged hexagonally on its plane is looped into a cylindrical shape. The CNTs are classified into single-walled CNTs or multiwall CNTs. Regardless of whether being single-walled or multiwall, the CNTs are expected to develop into functional materials such as electronic device materials, optical element materials, and electrically conducting materials because of their mechanical strength, optical properties, electrical properties, thermal properties, and molecular-adsorbing functions, etc. Among the CNTs, the single-walled CNTs are excellent in various properties such as electrical properties (extremely high in current density), heat properties (comparable in specific thermal conductivity to diamonds), optical properties (emit light in an optical communication band of wavelengths), hydrogen storage capability, and metal catalyst supporting capability. Moreover, the single-walled CNTs exhibit the properties of both semiconductors and metals, and therefore have drawn attention as materials for nanoelectronics devices, nanooptical elements, and energy storage bodies.

In the case of making efficient use of the CNTs for these purposes, it is desirable that a plurality of CNTs be aligned along a specific direction to form an aggregate in the form of a bundle, a film, or a mass, and that the CNT aggregate exhibit functionalities such as electric/electronic functionalities and optical functionalities. CNTs are a material that has an extremely high aspect ratio and is one-dimensionally structured. The functions of the CNTs are highly directional. Therefore, in a case where each of the CNTs constituting the CNT aggregate (structure) is aligned in a specific direction, functional directivities of the CNTs can be identically directed. It is therefore possible to produce a CNT aggregate having an excellent functionality.

That is, an aligned CNT aggregate in which the CNTs are aligned in the specific direction shows a highly directional transmissibility in a direction where the aligned CNT aggregate is aligned, compared to a CNT aggregate in which individual CNTs are aligned in an irregular direction, that is, the individual CNTs are not aligned. The CNT aggregate having such a great directivity shows more preferable electrical property (for example, a greater electrical conductivity), mechanical property (for example, a greater strength), and thermal property (for example, a greater thermal conductivity). Further, a property of a direction other than the direction where the CNT aggregate is aligned, that is, an anisotropy is efficient for, for example, selectively dispersing or discharging heat or the like in a desired direction. A CNT aggregate having such an anisotropy is suitably applicable to a thermally conductive material or the like. Further, it is preferable that the CNT aggregate be larger in its size such as height or length. It is predicted that creation of such an aligned CNT aggregate will lead to a dramatic expansion in the field of application of the CNTs.

A known method for producing such CNTs is a chemical vapor deposition method (hereinafter referred to also as "CVD method") (see e.g. Japanese Patent Application Publication No. 2003-171108 A). This method is characterized in bringing a carbon compound into contact with a catalyst, i.e., fine metal particles in a hot atmosphere of approximately 500°C to 1000°C, and as such, makes it possible to produce the CNTs with variations in aspects such as the kind and arrangement of the catalyst or the kind and condition of reaction of the carbon compound. The CVD method is, therefore, highly expected as being suitable to mass production of the CNTs. Further, the CVD method has the advantages of: being capable of producing both single-walled carbon nanotubes (SWCNTs) and multiwall carbon nanotubes (MWCNTs); and being capable of, by using a substrate supporting a catalyst, producing a large number of CNTs aligned perpendicularly to a surface of the substrate.

For example, Patent Literature 1 discloses a method for industrially producing carbon nanotubes on a silicon substrate in the presence of an oxidizing agent by means of the CVD method, thereby producing the carbon nanotubes with a higher purity, a greater specific surface area and an improved orientation thereof. Further, for example, Non-Patent Literature 1 discloses a method for producing the carbon nanotubes on a metal substrate (Ni based metal thin film substrate) that is lower-cost than the silicon substrate in the presence of the oxidizing agent by means of the CVD method.

Patent Literature 2 is related to structures that use carbon nanotubes to remove heat from integrated circuits and other solid-state devices, and discloses a method including *inter alia*: forming a first catalyst on top of a front surface of a copper substrate; forming a second catalyst on top of a back surface of a copper substrate; growing a first layer containing carbon nanotubes on the first catalyst; and growing a second layer containing carbon nanotubes on the second catalyst.

Patent Literature 3 is related to heat sinks which conduct heat by employing carbon nanotubes, and discloses a manufacturing method thereof comprising the steps of (a) providing a heat sink preform comprising a base and a plurality of fins extending from a first surface of the base; (b) polishing an opposite second surface of the base; (c) depositing a catalyst film on the second surface of the base; and (d) providing a carbon source gas to grow a plurality of carbon nanotubes on the second surface of the base.

Employing a low-cost metal substrate so as to produce the carbon nanotubes makes it possible to attain low cost for producing the carbon nanotubes thereby providing a high-quality and low-cost carbon nanotubes.

Citation List

Patent Literature

Patent Literature 1
International Publication No. WO 2006/011655 A1, pamphlet (Publication Date: February 2, 2006)
Patent Literature 2
US 2008/0131655 A1
Patent Literature 3
US 2005/0092464 A1

Non-Patent Literature

Non-Patent Literature 1

"Hyoumen Kagaku (Journal of The Surface Science Society of Japan)" vol. 28 No. 2, 2007, p. 104-110

Summary of Invention

Technical Problem

In the conventional CVD method, carbonaceous impurities that are generated during synthesis of CNTs cover catalyst particles. This easily deactivates the catalyst. As a result, the CNTs are prevented from being efficiently grown. The catalyst normally has an activity of a few percentages, and a life of approximately 1 minute. Therefore, it is normal to synthesize the CNTs in a low-concentrated carbon atmosphere in a conventional process for growing single-walled CNTs. What is meant by the low-concentrated carbon atmosphere is a growth atmosphere where a raw material gas accounts for approximately 0.1% to 1% of total flow. In a case where a carbon concentration is increased in a conventional synthesis method, the catalyst is more easily deactivated. This leads to further decrease in growth efficiency of the CNTs.

On this account, according to the conventional synthesis method, the raw material gas in a small amount is supplied to the catalyst. This causes a low growth rate of the CNTs. The conventional synthesis method also can produce merely single-walled aligned CNT aggregates having a height in the order of several tens of $\mu$m. Further, according to the conventional synthesis method, a carbon efficiency (a ratio of a supplied raw material gas converted into the CNTs) is extremely poor in an actual process for growing the CNTs, and most of the supplied raw material gas is accordingly wasted. This also causes a cost problem.

The inventors of the present invention found that a catalyst efficiency is dramatically improved by adding a fairly small amount of catalyst activation material (such as water) to a reaction atmosphere, and reported in Patent Literature 1 that single-walled CNTs having great carbon efficiency, purity, specific surface area and orientation can be more efficiently produced by adding a fairly small amount of catalyst activation material to a reaction atmosphere as such.

The catalyst activation material added to an atmosphere of synthesizing the CNTs removes the carbonaceous impurities covering the catalyst particles, and cleans a skin surface of the catalyst. This extremely improves activation of the catalyst and extends the life of the catalyst. As a result of improved activation of the catalyst and extended life of the catalyst due to the addition of the catalyst activation material, the single-walled CNTs are continuously grown for several tens of minutes though, conventionally, the single-walled CNTs were grown for merely approximately 2 minutes. Further, although the catalyst conventionally had the activity of merely a few percentages, the catalyst has an improved activity of 84% by adding the catalyst activation material. Hence, though the single-walled aligned CNT aggregates were conventionally merely 4 $\mu$m high, the single-walled aligned CNT aggregates are several hundreds times as high as the conventional single-walled aligned CNT aggregates by adding the catalyst activation material (in Patent Literature 1, the single-walled aligned CNT aggregates having a height of 2.5 millimeter that is 625 times as high as 4 $\mu$m). This is attained by significantly improving the catalyst activation due to the presence of the catalyst activation material thereby preventing the catalyst from being deactivated even in an a high-concentrated carbon atmosphere, enabling the growth of the CNTs for a long time period, and remarkably improving a growth rate of the CNTs. What is meant by the high-concentrated carbon atmosphere is a growth atmosphere where the raw material gas accounts for approximately 2% to 20% of the total flow.

The CNT synthesis in the presence of the catalyst activation material under high-concentrated carbon atmosphere as described in Patent Literature 1 makes it possible to synthesize the CNTs having more excellent growth efficiency, carbon efficiency and growth rate than those of the conventional CNTs. However, in a case where the aligned CNT aggregates are produced by the technique of Patent Literature 1, the technique of Patent Literature 1 faces a technical problem uniquely associated with the CNT synthesis in the presence of the catalyst activation material under high-concentrated carbon atmosphere, unlike the conventional synthesis method.

The method disclosed in Non-Patent Literature 1 causes deformation (warping or the like) of the metal substrate in a case where the carbon nanotubes are produced by means of the CVD method. The inventors of the present invention examined why the metal substrate was deformed, and found that the metal substrate was deformed mainly because the metal substrate is carburized by being exposed to a high-temperature carbon atmosphere during the growth of the carbon nanotubes. In the high-concentrated carbon atmosphere as described above, the growth rate of the aligned CNT aggregates is increased, however the metal substrate is increasingly deformed. Further, it is necessary to increase a surface area of the metal substrate in order to industrially produce a large amount of carbon nanotubes. However, a metal substrate with a greater surface area is more apt to deform. Further, it is also necessary to repetitively use the metal substrate in order to produce the carbon nanotubes at low cost. However, repetitive use of the metal substrate possibly causes the metal substrate to be further deformed.

The deformation of the metal substrate during CVD causes change in gas flow around a surface of the metal substrate. This possibly leads to unevenly growing the carbon nanotubes on the metal substrate, or causes a problem in a case where the carbon nanotubes are detached from the metal substrate. Further, increase in deformation degree of the metal substrate due to the repetitive use of the metal substrate possibly inhibits the growth of the carbon nanotubes, or causes a problem in a case where the metal substrate is cleaned or a catalyst layer is formed on the surface of the metal substrate.

The present invention was made in view of the problems, and an illustrative object of the present invention is to provide: a low-cost substrate for producing aligned carbon nanotube aggregates and a method for producing the aligned carbon nanotube aggregates, on which substrate high-quality carbon nanotubes can be efficiently produced by preventing deformation or the like caused by repetitive use of the substrate.

Solution to Problem

Inventors of the present invention examined in detail why decrease in productivity and deterioration in quality of carbon nanotubes are caused in a case of continuous production of the carbon nanotubes, and found that deformation of a substrate for producing aligned carbon nanotube aggregates, which substrate is employed in a carbon nanotube continuous production apparatus, is prevented by forming a carburizing prevention layer on the substrate whereby it is possible to prevent the decrease in productivity and the deterioration in quality of the carbon nanotubes in the case of the continuous production.

That is, a substrate of the present invention for producing aligned carbon nanotube aggregates is a substrate for producing aligned carbon nanotube aggregates on a surface thereof, the substrate for producing aligned carbon nanotube aggregates including: a metal base substrate made from an Fe-Cr alloy, an Fe-Ni alloy, or an Fe-Cr-Ni alloy; and carburizing prevention layers formed on both front and back surfaces of the metal base substrate, respectively.

A method of the present invention for producing aligned carbon nanotube aggregates is a method for producing aligned carbon nanotube aggregates on a surface of a substrate for producing aligned carbon nanotube aggregates as set forth above, the method including the steps of: causing the substrate for producing aligned carbon nanotube aggregates to be surrounded by a raw material gas environment constituted by a raw material gas; heating at least either the substrate for producing aligned carbon nanotube aggregates or the raw material gas; and producing, by means of chemical vapor deposition, the aligned carbon nanotube aggregates on the surface of the substrate for producing aligned carbon nanotube aggregates.

Advantageous Effects of Invention

According to the present invention, in a case where carbon nanotubes are produced on a substrate for producing aligned carbon nanotube aggregates, deformation of the substrate can be decreased or prevented by preventing the substrate from being carburized. As a result, it is possible to evenly grow the carbon nanotubes and prevent problems in a step for peeling off the carbon nanotubes from the substrate and in a step for washing the substrate. It is therefore possible to prevent decrease in productivity of the carbon nanotubes and deterioration in quality of the carbon nanotubes. Further, it is also possible to efficiently produce the carbon nanotubes at low cost.

What is meant by "carburizing" in the present invention is a technique for hardening a steel surface by ejecting carbon into the steel surface. The carburizing is carried out by introducing a gas (containing carbon monoxide that is a main ingredient, carbon dioxide, hydrogen and the like for adjusting a concentration of the carbon) into a heat furnace into which the steel is put, and then carburizing the steel at a high temperature of not less than 900°C for a long time period.

In a case where the carbon nanotubes are produced on a metal base substrate, a condition for growing the carbon nanotubes is similar to a condition for carburizing the metal substrate, that is, exposing the metal substrate to a high-temperature carbon atmosphere. Therefore, in a case where a carburizing prevention layer is not provided on the metal base substrate, it is considered that the metal base substrate is carburized, and carbon excessively corrodes the metal substrate along a surface of the metal base substrate and an internal grain boundary of the metal base substrate. This prevents the carbon nanotubes from growing on the surface of the metal base substrate and causes deformation of the metal substrate due to carbon or carbide generated on the grain boundary.

Brief Description of Drawings

Fig. 1

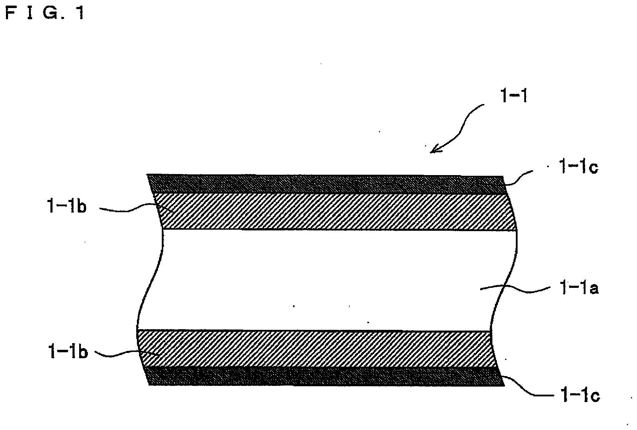

Fig. 1 is a view schematically showing a layer structure constituting a substrate for producing aligned carbon nanotube aggregates.
Fig. 2

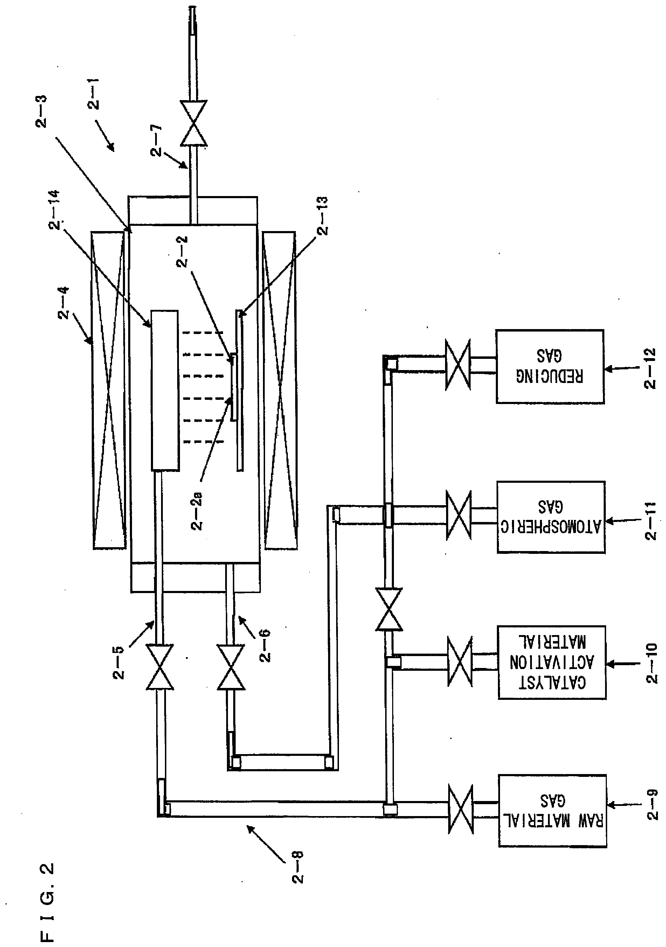

Fig. 2 is a side view conceptually showing a carbon nanotube production apparatus employing the substrate for producing the aligned carbon nanotube aggregates in accordance with an embodiment of the present invention.
Fig. 3

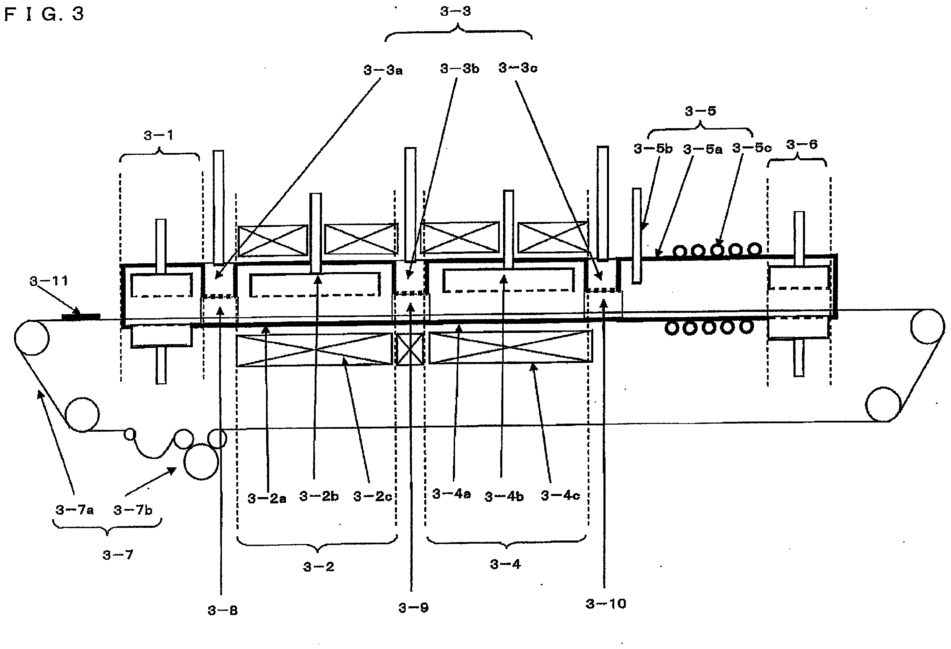

Fig. 3 is a side view conceptually showing a carbon nanotube continuous production apparatus employing the substrate for producing the aligned carbon nanotube aggregates in accordance with an embodiment of the present invention.
Fig. 4

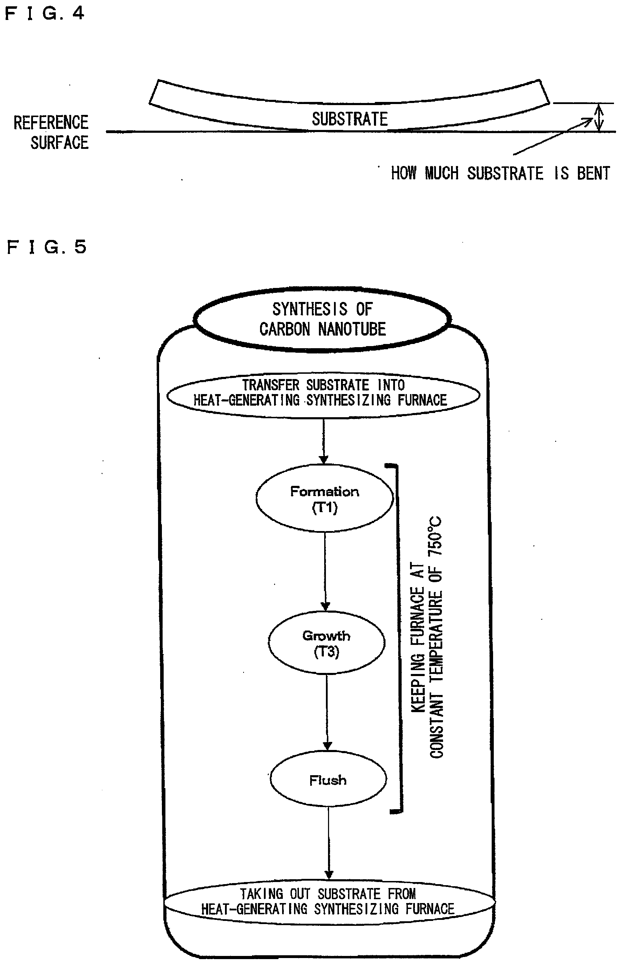

Fig. 4 is a view showing measurement of how much a substrate is deformed.
Fig. 5
Fig. 5 is a flowchart of a method for producing single-walled aligned CNT aggregates in accordance with the present invention.
Fig. 6

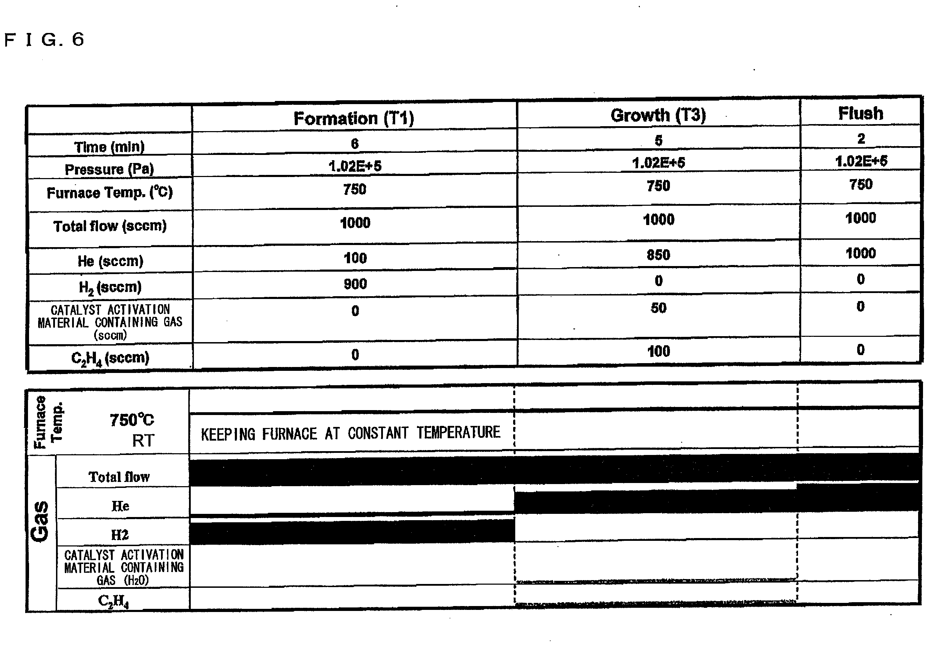

Fig. 6 is a detailed process condition of the single-walled aligned CNT aggregates in accordance with the present invention.
Fig. 7

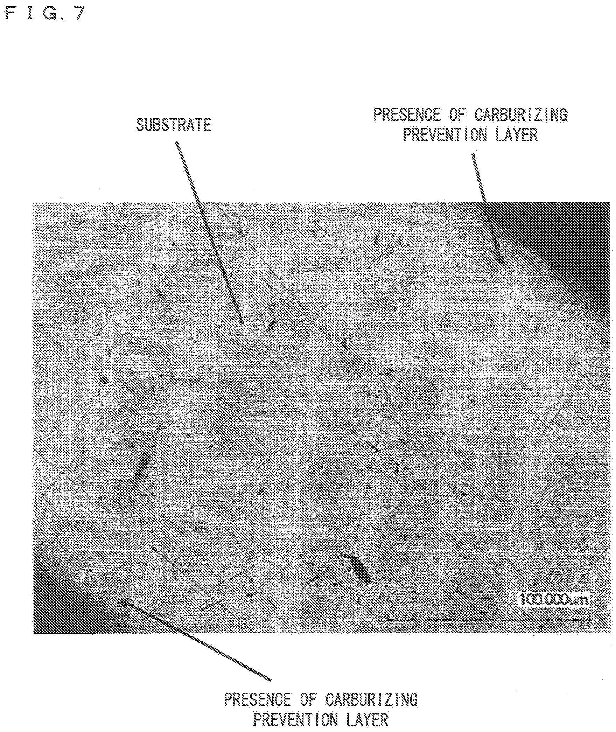

Fig. 7 is a photomicrograph obtained by observing, by use of a laser microscope, a cross section of a substrate employed in First Example.
Fig. 8

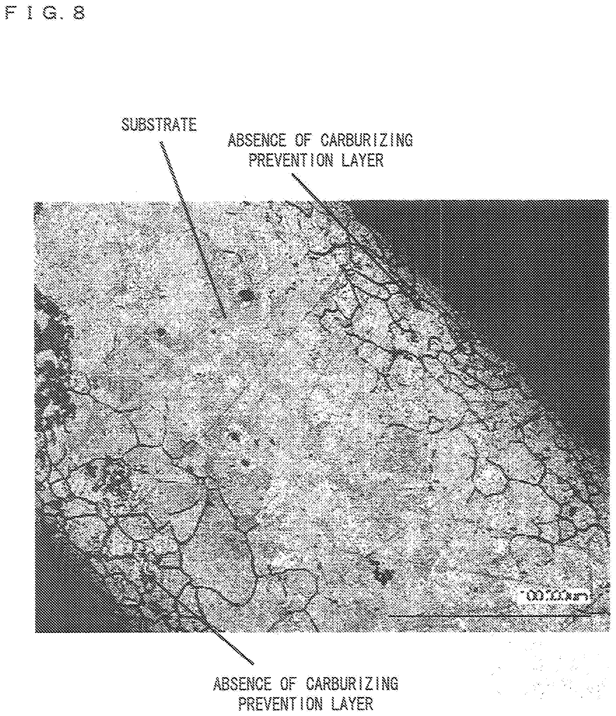

Fig. 8 is a photomicrograph obtained by observing, by use of the laser microscope, a cross section of a substrate employed in Comparative Example 1.
Fig. 9

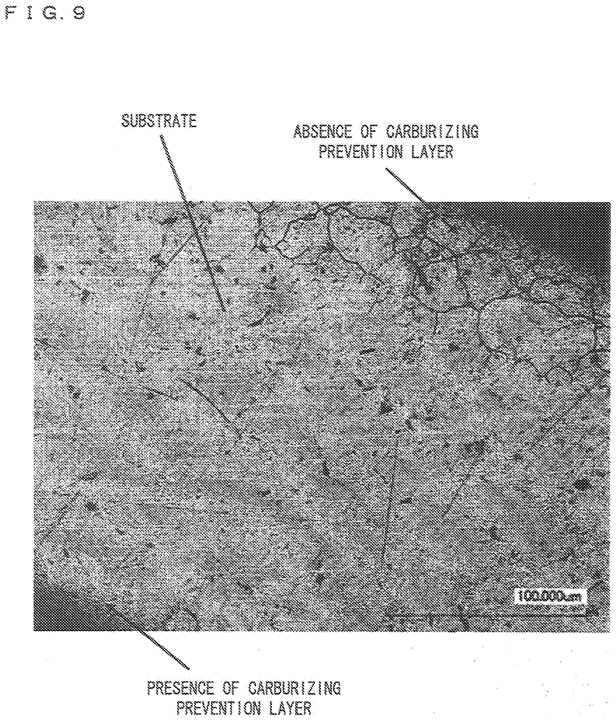

Fig. 9 is a photomicrograph obtained by observing, by use of the laser microscope, a cross section of a substrate employed in Comparative Example 2.

Description of Embodiments

(Aligned CNT Aggregate)

A plurality of CNTs are efficiently produced with use of a raw material gas from a catalyst formed on a substrate of the present invention for producing aligned carbon nanotube aggregates in a high-concentrated carbon environment and a catalyst activation material containing atmosphere. Such a plurality of CNTs produced from the catalyst are aligned in a specific direction to form an aligned CNT aggregate.

A single-walled aligned CNT aggregate produced on the substrate for producing the aligned CNT aggregates in accordance with the present invention has a great specific surface area and a low bulk density, and includes individual CNTs aligned in a specific direction. Such excellent properties of the single-walled aligned CNT aggregate are properties that a conventional CNT aggregate does not have. The specific surface area of the single-walled aligned CNT aggregate is extremely great, for example, not less than 600 m$^2$/g but not more than 2600 m$^2$/g. The single-walled aligned CNT aggregate having such a great specific surface area is suitably applicable to a catalyst support, an energy reservoir or a material reservoir, more specifically, a super capacitor, an actuator or the like. Further, as described above, the individual CNTs aligned in the specific direction constitute the aligned CNT aggregate. Therefore, the individual CNTs function identically with one another. In this manner, a CNT aggregate having an excellent property is produced.

Further, the single-walled aligned CNT aggregate has a low weight density of, for example, not less than 0.002 g/cm$^3$ but not more than 0.2 g/cm$^3$. The single-walled aligned CNT aggregate that grows with such a low weight density on the substrate includes individual single-walled CNTs weakly bonded to one another. Due to the weak bonding, it is easy to evenly disperse in a solvent or the like the single-walled aligned CNT aggregate detached from the substrate. Furthermore, the single-walled aligned CNT aggregate of the present invention is moderately aligned with the low weight density. It is therefore easy to adjust the density of the single-walled aligned CNT aggregate in a posttreatment process after production of the single-walled aligned CNT aggregate. Further, the single-walled aligned CNT aggregate can be densified by high-densely condensing CNTs with no space between the CNTs adjacent to each other as if the single-walled aligned CNT aggregate were a straw bag made of bundle of straw. Controlling the densification condition makes it possible to produce the single-walled aligned CNT aggregate in various shapes.

(Specific Surface Area)

The single-walled aligned CNT aggregate includes a bulk single-walled aligned CNT aggregate and a powder single-walled aligned CNT aggregate. The single-walled aligned CNT aggregate preferably has a specific surface area of not less than 600 m$^2$/g in a case where the CNTs are mostly unopened, and a specific surface area of not less than 1300 m$^2$/g in a case where the CNTs are mostly opened.

The single-walled aligned CNT aggregate having the specific surface area of not less than 600 m$^2$/g with the CNTs unopened and the single-walled aligned CNT aggregate having the specific surface area of not less than 1300 m$^2$/g with the CNTs opened contain less impurities such as metals or carbon impurities (e.g., not greater than several tens of percent [approximately 40%] of the weight of the single-walled aligned CNT aggregate). Further, the single-walled aligned CNT aggregate shows an original property of the CNTs. Therefore, the single-walled aligned CNT aggregate is suitably applicable to a catalyst support, an energy or material reservoir, a super capacitor, an actuator or the like.

Generally described, the single-walled aligned CNT aggregate preferably has a greater specific surface area. However, the single-walled aligned CNT aggregate theoretically has an upper limit of the specific surface area. Specifically, the single-walled aligned CNT aggregate with the CNTs unopened has the upper limit of approximately 1300 m$^2$/g, and the single-walled aligned CNT aggregate with the CNTs opened has the upper limit of approximately 2600 m$^2$/g.

(Orien tation)

The single-walled aligned CNT aggregate produced on the substrate for producing the aligned CNT aggregates in accordance with the present invention has a Herman's orientation factor of preferably more than 0 but less than 1, more preferably not less than 0.25 but not more than 1. The Herman's orientation factor is calculated on the basis of an X-ray diffraction intensity obtained by $\theta$-$2\theta$ method or Laue method, or an intensity profile obtained on the basis of an image obtained by subjecting an SEM image or an atomic force microscope (hereinafter referred to also as AMF) image to fast Fourier transformation. How to evaluate the orientation is described in detail later. The single-walled aligned CNT aggregate having such a Herman's orientation factor has excellent electric, mechanical and thermal properties, and a great specific surface area. The single-walled aligned CNT aggregate is also well-integrated, easy to handle, and easy to shape. Further, the single-walled aligned CNT aggregate thermodynamically, electrically and mechanically has an excellent anisotropy. Therefore, the single-walled aligned CNT aggregate is suitable for various applications.

Meanwhile, a single-walled aligned CNT aggregate having a Herman's orientation factor of less than 0 does not show orientation at all. Further, a single-walled aligned CNT aggregate having a Herman's orientation factor of less than 0.25 is such that CNTs are inclined by 45°. This shows that such a single-walled aligned CNT aggregate shows less orientation. Note that a single-walled aligned CNT aggregate having a Herman's orientation factor of 1 is fully aligned.

It is preferable that the single-walled aligned CNT aggregate have a height (length) of not less than 10 $\mu$m but not more than 10 cm so as to have an orientation and a great specific surface area. The single-walled aligned CNT aggregate having such a height has a preferable orientation and a great specific surface area. A single-walled aligned CNT aggregate having a height of not less than 10 $\mu$m has an improved orientation. Further, a single-walled aligned CNT aggregate having a height of not more than 10 cm can be produced at short times. It is therefore possible to prevent attachment of carbonaceous impurities, and to increase the specific surface area of the single-walled aligned CNT aggregate. Further, the single-walled aligned CNT aggregate having such a height is well-integrated, easy to handle, and easy to shape.

The orientation of the aligned CNT aggregate can be evaluated by at least any one of the following methods 1 to 3. The methods are:

1. In a case where the aligned CNT aggregate is irradiated with X rays from a first direction parallel with the longitudinal direction of the CNTs and from a second direction perpendicular to the first direction, and an x-ray diffraction intensity of the aligned CNT aggregate is then measured (by $\theta$-$2\theta$ method), a $\theta$ angle and a reflection direction where a reflection intensity from the second direction is greater than that from the first direction are obtained. Further, a $\theta$ angle and a reflection direction where the reflection intensity from the first direction is greater than that from the second direction are obtained.

2. In a case where an X-ray diffraction intensity is measured from a two-dimensionally diffraction pattern image obtained by irradiating the aligned CNT aggregate with X rays from the direction perpendicular to the longitudinal direction of the CNTs (Laue method), a diffraction peak pattern indicating presence of anisotropy appears.

3. A Herman's orientation factor calculated on the basis of the X-ray diffraction intensity obtained by $\theta$-$2\theta$ method or Laue method is more than 0 but less than 1, preferably not less than 0.25 but not more than 1.

According to the X-ray diffraction method, (i) diffraction intensities of a (CP) diffraction peak and a (002) peak based on packing between the single-walled CNTs, and (ii) a diffraction peak intensity in a direction of X-rays that enter parallel and perpendicular to (100) and (110) peaks based on a six-membered carbon ring constituting the single-walled CNTs are different from each other.

(Weight Density)

The single-walled aligned CNT aggregate produced on the substrate for producing the aligned CNT aggregates in accordance with the present invention has a weight density of, for example, not less than 0.002 g/cm$^3$ but not more than 0.2 g/cm$^3$. The weight density can be controlled by adjusting a density and types of catalyst particles.

The single-walled aligned CNT aggregate having the weight density of not less than 0.002 g/cm$^3$ but not more than 0.2 g/cm$^3$ can be densified by high-densely condensing CNTs with no space between the CNTs adjacent to each other as if the single-walled aligned CNT aggregate were a straw bag made of bundle of straw. Controlling the densification condition by, for example, a method described in "Nature Materials" vol. 5 (2006) pages 987 to 994 makes it possible to form the single-walled aligned CNT aggregate in various shapes such as a high-density film shape.

The single-walled aligned CNT aggregate having the weight density of not more than 0.2 g/cm$^3$ includes CNTs weakly bonded to each other. Due to the weak bonding, it is possible to evenly disperse with stirring the single-walled aligned CNT aggregate in a solvent or the like. The single-walled aligned CNT aggregate is also adequately hard and integrated. It is therefore possible to form the produced single-walled aligned CNT aggregate into various shapes by densifying the produced single-walled aligned CNT aggregate. Further, the single-walled aligned CNT aggregate having the weight density of not less than 0.002 g/cm$^3$ is not dispersed but well-integrated so as to be suitably shaped.

(Substrate for producing aligned carbon nanotube aggregates)

It is desirable that the substrate (substrate for producing aligned carbon nanotube aggregates) has a surface on which a carburizing prevention layer and a catalyst are formed, and which is for example flat, and made up of a material that is not deformed at a high temperature of not less than 500°C.

Specifically, in the present invention, a metal base substrate made from an Fe-Cr alloy, an Fe-Ni alloy, or an Fe-Cr-Ni alloy is employed as a base substrate. This is because it is easy to prepare a large-sized and lower-cost metal base substrate, compared to a silicon or ceramic base substrate. Meanwhile, conventionally used silicon base substrate, ceramic base substrate, glass base substrate and like base substrates are not so carburized as the metal base substrate, and therefore do not cause deformation of the base substrate. Further, the material of the base substrate is an Fe-Cr alloy, an Fe-Ni alloy, or an Fe-Cr-Ni alloy because these alloys are low in cost and brings a preferable growth of the CNTs.

A thickness of the metal base substrate is not particularly limited. For example, a metal base substrate having a thickness of a few micrometers to a few centimeters can be employed. The metal base substrate preferably has a thickness of not less than 0.05 mm but not more than 3 mm. The metal base substrate having a thickness of not more than 3 mm can be sufficiently heated during CVD, and enables to prevent insufficient growth of the carbon nanotubes. Further, the metal base substrate having such a thickness contributes to decrease in cost of the metal base substrate. The metal base substrate having a thickness of not less than 0.05 mm cannot be deformed by carburization, and is hard to be bended. This makes it possible to suitably transfer the metal base substrate.

A problem caused by the deformation of the base substrate depends on an amount of deformation of the base substrate. The amount of deformation of the base substrate depends on the process for producing aligned CNT aggregates. The following describes, as an example, the amount of deformation of the base substrate. In a case where a catalyst is formed on a surface of the base substrate by means of sputtering, a thickness of the catalyst to be formed on the surface of the base substrate depends on a distance between the base substrate and a target. Therefore, in order to make the thickness of the catalyst even, it is preferable that the base substrate be deformed by less than 10 mm.

In a case where the catalyst layer has an uneven thickness, there is a possibility that the carbon nanotubes unevenly grow, or that the carbon nanotubes have a reduced specific surface area. Further, in a case where during the CVD, the substrate on which the carbon nanotubes are growing is deformed, gas flow around the surface of the substrate is changed. This possibly causes uneven growth of the carbon nanotubes or decrease in the specific surface area or a G/D ratio. Further, change in a distance between a shower head to be described later and the substrate also possibly causes the uneven growth of the carbon nanotubes or the decrease in the specific surface area or the G/D ratio. In order to evenly grow the carbon nanotubes having desired specific surface area and G/D ratio on the substrate, it is preferable that the base substrate be deformed by less than 10 mm.

A shape of the base substrate is not particularly limited. A rectangular or square substrate can be employed. Further, one side of the base substrate is not particularly limited in terms of its length. For example, a base substrate having a side of approximately 1 cm, which is conventionally used, is deformed by at most a few millimeters. Such an amount of deformation less causes the problem. Meanwhile, the base substrate preferably has a long side in terms of productivity of the carbon nanotubes. Specifically, it is preferable that one side be not less than 9 cm long. However, the base substrate having a side of approximately 9 cm is possibly deformed by approximately 10 mm. Meanwhile, the present invention makes it possible to prevent such an amount of deformation. Therefore, an effect of the present invention is noticeably attained by solving the problem.

(Carburizing Prevention Layer, Catalyst)

The carburizing prevention layer formed on both front and back surfaces of the base substrate is a protecting layer for preventing the base substrate from being carburized and therefore deformed in the steps of producing the carbon nanotubes.

It is preferable that the carburizing prevention layer be composed of a metal or ceramic material, or especially preferably the ceramic material, which is highly effective in preventing carburizing. Examples of the metal include copper and aluminum.

Examples of the ceramic material include: oxides such as aluminum oxide, silicon oxide, zirconium oxide, magnesium oxide, titanium oxide, silica alumina, chromium oxide, boron oxide, calcium oxide, and zinc oxide; and nitrides such as aluminum nitride and silicon nitride. Among them, aluminum oxide and silicon oxide are preferable because they are highly effective in preventing carburizing. What is meant by "mainly containing the ceramic material" of the present invention is that the ceramic material accounts for most of whole material.

A catalyst for the growth of the CNTs to be described later is formed on the carburizing prevention layer. Meanwhile, in a case where the material of the carburizing prevention layer is identical to that of the catalyst, the carburizing prevention layer can also be functioned as the catalyst.

The carburizing prevention layer preferably has a thickness of not less than 0.01 $\mu$m but not more than 1.0 $\mu$m. The carburizing prevention layer having a thickness of not less than 0.01 $\mu$m can sufficiently attain a carburizing prevention effect. The carburizing prevention layer having a thickness of not more than 1.0 $\mu$m can be sufficiently heated during the CVD because change in a thermal conductivity of the substrate on which the carburizing prevention layer is formed is prevented. This makes it possible to prevent the insufficient growth of the carbon nanotubes. The carburizing prevention layer can be formed (coated) by, for example, a physical method such as vapor deposition or sputtering, CVD or coating.

As described above, the catalyst for the growth of the CNTs is formed on the carburizing prevention layer. Any type of catalyst that is usable for production of the CNTs can be used. Examples of the catalyst include iron, nickel, cobalt, molybdenum, a chloride thereof, an alloy thereof, and a complex or layer thereof with aluminum, alumina, titania, titanium nitride, or silicon oxide. Examples that can be given are an iron-molybdenum thin film, an alumina-iron thin film, an alumina-cobalt thin film, an alumina-iron-molybdenum thin film, an aluminum-iron thin film, and an aluminum-iron-molybdenum thin film.

The catalyst can be used in a range of existential quantities that is usable for production of the CNTs. For example, in the case of use of iron, it is preferable that the thickness of a layer formed be in a range of not less than 0.1 nm but not more than 100 nm, more preferably not less than 0.5 nm but not more than 5 nm, or especially preferably not less than 0.8 nm but not more than 2 nm.

It is possible to apply either a wet or dry process to the formation of the catalyst layer onto the surface of the substrate. Specifically, it is possible to apply a sputtering evaporation method or a method for spreading or calcining a liquid obtained by dispersing fine metal particles in an appropriate solvent. Further, it is possible to form the catalyst into any shape with concomitant use of patterning obtained by applying well-known photolithography, nanoinprinting, or the like. A production method of the present invention makes it possible to arbitrarily control the shape of the single-walled aligned CNT aggregate, according to the catalyst patterning formed on the substrate and the growth time for the CNTs, so that the single-walled aligned CNT aggregate takes a thin-film shape, a cylindrical shape, a prismatic shape, or any other complicated shapes.

In particular, in the shape of a thin film, the single-walled aligned CNT aggregate has an extremely small thickness (height) as compared with its length and width; however, the length and width can be arbitrarily controlled according to the catalyst patterning, and the thickness can be arbitrarily controlled according to the growth time for the single-walled CNTs that constitute the single-walled aligned CNT aggregate.

In a case where the catalyst is formed on both the front and the back surfaces of the substrate, the aligned CNT aggregate can be grown on both surfaces of the substrate. Therefore, this is desirable in terms of productivity. In consideration of production cost, production process or the like, it is of course possible to form the catalyst on one surface of the substrate.

Fig. 1 schematically shows a substrate for producing aligned CNT aggregates in accordance with the present invention. A substrate 1-1 includes a metal base substrate 1-1a having a preferable thickness of 0.05 mm to 3 mm. A carburizing prevention layer 1-1b is formed on both front and back surfaces of the metal base substrate 1-1a. The carburizing prevention layer 1-1b is preferably made from a ceramic material, and has a thickness of 0.01 $\mu$m to 1.0 $\mu$m. A catalyst (catalyst layer) 1-1c is further formed on the carburizing prevention layer 1-1b. Iron-cobalt, iron-molybdenum or the like is employed as the catalyst, and the catalyst layer has a substantial thickness of 0.1 nm to 100 nm.

It is desirable that, for the base substrate as well as the carburizing prevention layer of the substrate surface, and the base substrate including the catalyst, the arithmetic average roughness Ra of their surface is not more than 3 $\mu$m. The substrate having such an arithmetic average roughness makes it possible to prevent or decrease attachment of carbon dirt to the surfaces of the substrate, and suppress to be carburized. It is therefore possible to efficiently produce high-quality carbon nanotubes. The arithmetic average roughness Ra is calculated, as established in "JIS B 0601-2001", by the following formula where surface profile y = f (x) represented by (i) an X-axis positioned in a direction of an average line of a reference length L extracted in the direction of the average line from a roughness curve and (ii) a Y-axis positioned in a direction of a longitudinal magnification perpendicular to the X-axis.

[Math 1]

$$Ra = \frac{1}{L} \int_0^L |f(x)| dx$$

(Reducing Gas)

In general, a reducing gas is a gas that has at least one of the effects of reducing a catalyst, stimulating the catalyst to become fine particles suitable for the growth of the CNTs, and improving the activity of the catalyst, and that is in a gaseous state at a growth temperature.

Any type of reducing gas that is usable for production of the CNTs can be used. However, a typically applicable example of the reducing gas is a gas having a reducing ability, such as hydrogen gas, ammonium, water vapor, or a mixture thereof. Alternatively, it is possible to apply a mixed gas obtained by mixing hydrogen gas with an inert gas such as helium gas, argon gas or nitrogen gas. The reducing gas is generally used in a formation step, but may be used in a growth step as appropriate.

(Raw Material Gas)

As a raw material for use in generation of the CNTs in the present invention, any type of raw material that is usable for production of the CNTs can be used. In general, gasses having raw-material carbon sources at the growth temperature can be used.

Among them, hydrocarbons such as methane, ethane, ethylene, propane, butane, pentane, hexane, heptanepropylene, and acetylene are suitable. In addition, lower alcohols such as methanol and ethanol, acetone, oxygen-containing compounds having small numbers of carbon atom such as carbon monoxide, and a mixture thereof can be used. Further, the raw material gas may be diluted with an inert gas.

(Catalyst Activation Material)

It is possible to add a catalyst activation material in the CNT growth process. The addition of the catalyst activation material makes it possible to further improve the efficiency in the production of the carbon nanotubes and the purity of the carbon nanotubes. In general, the catalyst activation material used here only needs to be an oxygen-containing substance that does no significant damage to the CNTs at the growth temperature. Effective examples other than water vapor include: hydrogen sulfide; oxygen-containing compounds having small numbers of carbon atom such as oxygen, ozone, acidic gases, nitrogen oxide, carbon monoxide and carbon dioxide; alcohols such as ethanol and methanol; ethers such as tetrahydrofuran; ketones such as acetone; aldehydes; esters; nitrogen oxide; and mixtures thereof. Among them, water vapor, oxygen, carbon dioxide, carbon monoxide, and ethers such as tetrahydrofuran are preferable. In particular, water vapor is suitable.

The catalyst activation material is not particularly limited in amount to be added. Normally, however, the catalyst activation material only needs to be added in minute amounts. For example, when the catalyst activation material is water vapor, the catalyst activation material only needs to be added in a range of not less than 10 ppm but not more than 10,000 ppm, preferably not less than 50 ppm but not more than 1,000 ppm, more preferably not less than 200 ppm but not more than 700 ppm.

The mechanism by which the catalyst activation material functions is deduced at this stage as follows: In the process of growth of the CNTs, adhesion of by-products such as amorphous carbon and graphite to the catalyst causes deactivation of the catalyst, and the growth of the CNTs is therefore inhibited. However, the presence of the catalyst activation material causes amorphous carbon, graphite and the like to be oxidized into carbon monoxide or carbon dioxide and therefore gasified. Therefore, the catalyst activation material is believed to cleanse the catalyst and express the function (catalyst activation function) of enhancing the activity of the catalyst and extending the active life of the catalyst.

With the catalyst activation material thus added, the activity of the catalyst is enhanced and the life of the catalyst is extended. When the catalyst activation material is added, the growth of the CNTs, which would continue for approximately two minutes at longest if the catalyst activation material were not added, continues for several tens of minutes, and the growth rate increases by a factor of not less than 100 or, furthermore, a factor of 1,000. As a result, an aligned CNT aggregate with a marked increase in height is obtained.

(Inert Gas)

The inert gas only needs to be a gas that is inert at the temperature at which the CNTs grow, and that does not react with the growing CNTs. Any type of inert gas that is usable for production of the CNTs can be used. Examples that can be given are helium, argon, nitrogen, neon, krypton, hydrogen, chlorine, and mixtures thereof. In particular, nitrogen, helium, argon, and mixtures thereof are suitable. Some raw material gases possibly react chemically with hydrogen. In this case, it is necessary to reduce the amount of hydrogen to be used but it is necessary that the reduction of the amount of hydrogen do not inhibit the growth of the CNTs. In the case of use of ethylene as the raw material gas, it is preferable that a hydrogen concentration be not more than 1%.

(Atmospheric Pressure)

It is preferable that the atmospheric pressure be not less than $10^2$ Pa but not more than $10^7$ Pa (100 atm), or more preferably not less than $10^4$ Pa but not more than $3 \times 10^5$ Pa (3 atm).

(Reaction Temperature)

The reaction temperature at which the CNTs grow is appropriately determined in consideration of a metal catalyst, the raw-material carbon source, and a reaction pressure. In a case where the catalyst activation material is added in order to eliminate a by-product that causes deactivation of the catalyst, it is desirable that the reaction temperature be set in such a temperature range that the catalyst activation material sufficiently expresses its effect. That is, the most desirable temperature range has a lower-limit temperature at or above which the catalyst activation material can remove by-products such as amorphous carbon and graphite and a higher-limit temperature at or below which the CNTs, which are main products, are not oxidized by the catalyst activation material.

Specifically, in the case where the catalyst activation material is water, it is preferable that the reaction temperature be not less than 400°C but not more than 1,000°C. At 400°C or higher, the catalyst activation material sufficiently expresses its effect. At 1,000°C or lower, it is possible to prevent the catalyst activation material from reacting with the CNTs. Alternatively, in the case where the catalyst activation material is carbon dioxide, it is preferable that the reaction temperature be not less than 400°C but not more than 1,100°C. At 400°C or higher, the catalyst activation material sufficiently expresses its effect. At 1,100°C or lower, it is possible to prevent the catalyst activation material from reacting with the CNTs.

(Formation Step)

The formation step is a step of causing an environment surrounding the catalyst supported by the substrate to be an environment of the reducing gas and heating at least either the catalyst or the reducing gas. This step brings about at least one of the effects of reducing the catalyst, stimulating the catalyst to become fine particles suitable for the growth of the CNTs, and improving the activity of the catalyst. For example, when the catalyst is an alumina-iron thin film, the iron catalyst is reduced to become fine particles, whereby a large number of fine iron particles in nanometer size are formed on the alumina layer. Thus, the catalyst is prepared to be a catalyst suitable to production of the aligned CNT aggregate.

(Growth Step)

The growth step is a step of growing the aligned CNT aggregate by causing the environment surrounding the catalyst, which in the formation step has been put in a state suitable to the production of the CNTs, to be an environment of the raw material gas and by heating at least either the catalyst or the raw material gas.

(Production Apparatus)

A production apparatus used in the present invention inevitably includes a synthesizing furnace (reaction chamber) that accommodates the substrate supporting the catalyst and heating means. Meanwhile, other mechanisms and configurations of sections other than the synthesizing furnace and the heating means of the production apparatus are not particularly limited. Examples of the production apparatus encompass a thermal CVD furnace, a thermally heating furnace, an electric furnace, a drying furnace, a constant temperature bath, an atmospheric furnace, a gas replacement furnace, a muffle furnace, an oven, a vacuum heating furnace, a plasma reactor, a microplasma reactor, an RF plasma reactor, an electromagnetic heating reactor, a microwave reactor, an infrared heating furnace, an ultraviolet heating reactor, an MBE reactor, an MOCVD reactor, and a laser heating device.

Fig. 2 shows, as an example, a CVD apparatus (CVD apparatus 2-1) used in the present invention. The CVD apparatus 2-1 includes a tubular synthesizing furnace 2-3 and heating means 2-4. The synthesizing furnace 2-3 is made from, for example, quartz glass and accommodates a substrate (base substrate) 2-2 supporting the catalyst. The heating means 2-4 is, for example, a resistance heat generating coil that is provided around the synthesizing furnace 2-3.

Gas supply tubes 2-5 and 2-6 are connected to openings formed on a sidewall of the synthesizing furnace 2-3. A gas exhaust tube 2-7 is connected to an opening formed on the other sidewall of the synthesizing furnace 2-3. Each of the gas supply tubes 2-5 and 2-6 is connected to a raw material gas supply section 2-9, a catalyst activation material supply section 2-10, an atmospheric gas supply section 2-11 and a reducing gas supply section 2-12 via a collecting and dividing tube 2-8.

A substrate holder 2-13 is provided in a lower space of the synthesizing furnace 2-3. The substrate holder 2-13 holds thereon the substrate 2-2 having a catalyst layer formation surface 2-2a. Further, a shower head 2-14 is provided above the substrate holder 2-13. The shower head 2-14 is provided dispersedly with a plurality of nozzles. Moreover, the shower head 2-14 is connected to an end of the gas supply tube 2-5 through which end a gas flows toward the shower head 2-14. The nozzles of the shower head 2-14 are provided so as to face the catalyst layer formation surface 2-2a of the substrate 2-2 placed on the substrate holder 2-13.

Further, the nozzles are provided such that an ejection axis line of the nozzles extends toward the catalyst layer formation surface 2-2a of the substrate 2-2. That is, a direction of gas flow ejected from the nozzles provided in the shower head 2-14 is substantially orthogonal to the catalyst layer formation surface 2-2a of the substrate 2-2. According to the present embodiment, the ejection axis line (direction in which gas is ejected from the nozzles) of the nozzles extends orthogonally to the catalyst layer formation surface 2-2a of the substrate 2-2. This is adopted as an optimal design for adjusting the direction of gas flow ejected from the nozzles to an alignment direction of the CNTs that generally grow in a direction perpendicular to the catalyst layer formation surface 2-2a of the substrate 2-2.

That is, the configuration of the shower head 2-14 including distribution of the nozzles and an angle of the ejection axis line is not limited to the present embodiment as long as the configuration of the shower head allows the gas flow to reach the catalyst layer formation surface 2-2a of the substrate 2-2 so evenly that the evenness of the gas flow is practically acceptable, and as long as the configuration of the shower head do not allow the growing CNTs to inhibit the gas flow. Further, dispositions of the substrate 2-2, the substrate holder 2-13 and the shower head 2-14 are not limited to the present embodiment as long as the above-described condition is met. Further, each of the gas supply tubes 2-5 and 2-6, the gas exhaust tube 2-7 and the supply sections 2-9 to 2-12 is properly provided with a non-return valve, a flow control valve and a flow sensor. Opening and closing of the flow control valves are controlled as appropriate in response to a control signal supplied from a control device (not shown). This makes it possible to successively or intermittently supply to the synthesizing furnace 2-3 predetermined amounts of the raw material gas, the catalyst activation material, the atmospheric gas and the reducing gas through both of the gas supply tubes 2-5 and 2-6 or any one of the gas supply tubes 2-5 and 2-6 in accordance with a reaction process.

Further, the catalyst activation material supply section 2-10 is connected to another atmospheric gas supply section (not shown). The catalyst activation material and an atmospheric gas such as helium are supplied to the synthesizing furnace 2-3. The CVD apparatus 2-1 having such an arrangement can grow a plurality of CNTs in a substantially identical direction on the catalyst layer formation surface 2-2a of the substrate 2-2 by (i) ejecting from the nozzles of the shower head 2-14 connected to the gas supply tube 2-5 to the catalyst layer formation surface 2-2a of the substrate 2-2, as a shower, gases supplied through the collecting and dividing tube 2-8, (ii) supplying the gases into the synthesizing furnace 2-3 from the opening of the gas supply tube 2-6, or (iii) supplying the gases from the gas supply tubes 2-5 and 2-6.

(Synthesizing Furnace)

It is preferable that a material of the synthesizing furnace be a material that does not inhibit the growth of the CNTs, that can accommodate the substrate supporting the catalyst at the growth temperature at which the CNTs grow, and that can retain a thermal evenness in the synthesizing furnace. Any type of the material that is usable for production of the CNTs can be used. Among these materials, quartz and various metal materials are preferably used as the material. Further, the synthesizing furnace may be provided with a system by which a plurality of substrates are supplied/taken out into/from the synthesizing furnace at once or the substrate is successively supplied/taken out into/from the synthesizing furnace, so that a large amount of CNTs are synthesized.

(Material of Synthesizing Furnace)

It is preferable that a part of the production apparatus, particularly the synthesizing furnace be made from a heat-resistant alloy. Examples of the heat-resistant alloy encompass a heat-resistant steel, a stainless steel, and a nickel-based alloy. In general, a heat-resistant steel refers to a steel that contains Fe in major proportions and other alloys in concentrations of not greater than 50%, and a stainless steel refers to a steel that contains Fe in major proportions, other alloys in concentrations of not greater than 50%, and approximately not less than 12% of Cr. Further, examples of the nickel-based alloy include an alloy obtained by adding Mo, Cr, Fe, and the like to Ni. Specifically, SUS 310, Inconel 600, Inconel 601, Inconel 625, Incoloy 800, MC Alloy, and Haynes 230 Alloy are preferable in terms of heat resistance, mechanical strength, chemical stability, and low cost.

In a case where the CNTs are grown in an environment of high-carbon concentration, carbonaceous by-products other than the CNTs, such as amorphous carbon and graphite (hereinafter referred to as "carbon contaminants"), adhere to wall surfaces of the synthesizing furnace. Accumulation of a certain amount of the carbon contaminants in the synthesizing furnace leads to decrease in production quantity and deterioration in quality of the CNTs. However, the decrease in production quantity and the deterioration in quality of the aligned CNT aggregate can be prevented by forming an inner wall of the synthesizing furnace of the production apparatus and/or components for use in the synthesizing furnace of the production apparatus with a heat-resistant alloy containing nickel and chromium, and by either plating a surface of the heat-resistant alloy with molten aluminum or polishing the surface so that the surface has an arithmetic average roughness $Ra \leq 2\ \mu m$.

(Molten Aluminum Plating)

Molten aluminum plating means a process of forming an aluminum or aluminum alloy layer on a surface of an object by dipping the object into a bath of molten aluminum. More specifically, the process is carried out as follows: a surface of an object (base metal) is washed (preprocessed), and then the object is dipped into a bath of molten aluminum at approximately 700°C, thereby causing the molten aluminum to disperse into the surface of the base metal so as to form an alloy of the base metal and aluminum, so that the aluminum is adhered to the alloy layer when the base metal is withdrawn from the bath. Furthermore, the molten aluminum plating also encompasses a post-dipping process in which a Fe-Al alloy layer under the surface layer (the alumina layer and aluminum surface layer) is exposed by subjecting the surface layer to low-temperature thermal diffusion.

(Heating Means)

Conventionally well-known heating means such as a device employing heating wires and an infrared heating device can be employed for heating a chamber surrounding the reaction chamber.

(Means for supplying catalyst activation material)

Means for supplying the catalyst activation material is not particularly limited. Examples of the means include supplying the catalyst activation material with use of an atmospheric gas through a bubbler, supplying the catalyst activation material by vaporizing a solution containing the catalyst activation material, supplying the catalyst activation material as it is in a gaseous state, and supplying the catalyst activation material by liquefying or vaporizing a solid catalyst activation material. It is possible to build a supply system using various devices such as a vaporizer, a mixer, a stirrer, a diluter, a spray, a pump, and a compressor, so as to supply the catalyst activation material.

Further, in order to stably and accurately supply a small amount of the catalyst activation material as described above, the production apparatus is preferably provided with a purification device for removing the catalyst activation material component from the raw material gas and the atmospheric gas. Specifically, it is preferable that the catalyst activation material component is removed from the raw material gas and the atmospheric gas at an upstream in a supply path leading to the synthesizing furnace, and then a controlled amount of the catalyst activation material is added, at a downstream in the supply path leading to the synthesizing furnace, to the raw material gas and the atmospheric gas from which the components of the catalyst activation material have been removed. The above technique is applicable to a case where the raw material gas or the atmospheric gas contains a small amount of the catalyst activation material component.

Further, the catalyst activation material can be stably supplied with less fluctuation over time by providing the supply paths or exhaust tubes of the raw material gas and the atmospheric gas with a measurement device for measuring a concentration of the catalyst activation material, and by carrying out a feedback control of flow adjustment means for adjusting the flow of the catalyst activation material by use of an output value obtained by the measurement device.

The measurement device can be a device for measuring not only the concentration of the catalyst activation material but also how much the CNTs are synthesized, and a device that also measures an amount of by-products other than the CNTs, such as amorphous carbon and graphite generated due to usage of the catalyst activation material.

(Shower)

In order to supply the reducing gas, the raw material gas and the catalyst activation material, a shower head having a plurality of nozzles provided to face a catalyst layer formation surface of a substrate can be used. What is meant by "to face" is that ejection axis lines of the nozzles direct substantially orthogonally to the substrate (an angle made by the ejection axis lines and a normal line of the substrate ranges from not less than 0° to less than 90°). That is, gas flow ejected from the nozzles provided in the shower head directs substantially orthogonally to the substrate. Further, the catalyst layer formation surface is a surface or a space of the substrate on/in which surface or space a catalyst is placed. In general, if the substrate has a flat substrate, the flat surface serves as the catalyst layer formation surface.

Ejecting the reducing gas by use of such a shower head makes it possible to evenly scatter the reducing gas over the substrate thereby causing an efficient reducing of the catalyst. This leads to evenly growing the aligned CNT aggregate on the substrate and decrease in consumption quantity of the reducing gas. Further, ejecting the raw material gas by use of such a shower head makes it possible to evenly scatter the raw material gas over the substrate thereby causing an efficient consumption of the raw material gas. This leads to evenly growing the aligned CNT aggregate on the substrate and decrease in consumption quantity of the raw material gas. Furthermore, ejecting the catalyst activation material by use of such a shower head makes it possible to evenly scatter the catalyst activation material over the substrate thereby causing increase in the activity of the catalyst and extension of the life of the catalyst. This allows the aligned CNT aggregate to grow for a long time period.

(Continuous Production Apparatus)

A production apparatus of the present embodiment can be arranged as shown in Fig. 3. The production apparatus of Fig. 3 basically includes an inlet purge section 3-1, a formation unit 3-2, a gas mixing prevention means 3-3, a growth unit 3-4, a cooling unit 3-5, an outlet purge section 3-6, a transfer unit 3-7, and connection sections 3-8 to 3-10. The formation unit 3-2, the growth unit 3-4 and the cooling unit 3-5 include a formation furnace 3-2a, a growth furnace 3-4a and a cooling furnace 3-5a, respectively. The formation furnace 3-2a, the growth furnace 3-4a and the cooling furnace 3-5a are spatially connected to one another via the connection sections 3-8 to 3-10. A substrate (catalyst substrate) 3-11 is transferred to the formation furnace, the growth furnace and the cooling furnace in this order by the transfer unit 3-7.

(Inlet Purge Section)

The inlet purge section is a set of devices for preventing the outside air from flowing into the formation furnace of the apparatus through a substrate inlet, and has a function of replacing with a purge gas an environment surrounding the substrate transferred into the apparatus. Examples of the inlet purge section include a furnace or chamber in which the purge gas is retained and a gas ejection section for ejecting the purge gas. It is preferable that the purge gas be an inert gas. In particular, in terms of safety, cost, purging properties and the like, it is preferable that the purge gas be nitrogen. When the substrate inlet is always open as in the case of a belt-conveyor type, it is preferable to use, as a purge gas ejection section, a gas curtain device that ejects the purge gas from top and bottom in the form of a shower, in order to prevent the outside air from flowing in through an inlet of the apparatus.

(Formation Unit)

The formation unit is a set of devices for carrying out a formation step, and has a function of causing the catalyst formed on the surface of the substrate to be surrounded by a reducing gas environment constituted by a reducing gas, and heating at least either the catalyst or the reducing gas. Specific examples of the formation unit include a formation furnace in which the reducing gas is retained, a reducing gas ejection section for ejecting the reducing gas, and a heater for heating at least either the catalyst or the reducing gas. It is preferable that the heater be capable of heating to a temperature of not less than 400°C but not more than 1100°C. Examples of the heater include a resistance heater, an infrared heater, and an electromagnetic induction heater. Further, it is preferable that the formation unit be at least partially made from the above-described material for the furnace. Furthermore, the formation unit may be provided with the above-described shower head.

(Growth Unit)

The growth unit is a set of devices for carrying out a growth step, and has a function of synthesizing an aligned CNT aggregate by causing the catalyst, which has been put into a state suitable to production of the aligned CNT aggregate in the formation step, to be surrounded by a raw material gas environment constituted by a raw material gas, and by heating at least either the catalyst or the raw material gas. Specific examples of the growth unit include a growth furnace in which the environment of the raw material gas is retained, a raw material gas ejection section for ejecting the raw material gas, and a heater for heating at least either the catalyst or the raw material gas. The heater may be any heater that is capable of heating, but is preferably capable of heating to a heating temperature of not less than 400°C but not more than 1,100°C, examples of which include a resistance heater, an infrared heater, and an electromagnetic induction heater. It is preferable that the growth unit further include a section for adding the catalyst activation material. At least part of the growth unit is preferably made of the material of the synthesizing furnace described above. Further, the growth unit may be provided with the shower head described above.

(Transfer Unit)

The transfer unit is a set of devices necessary for transferring the substrate at least from the formation unit to the growth unit. Examples of the transfer unit include either a robot arm and a robot arm driving device in the case of a multi-chamber type, and a mesh belt and a drive device driven by a reducer-equipped electric motor in the case of a belt-conveyor type.

(Gas Mixing Prevention Means)

The gas mixing prevention means is a set of devices that is installed at the connecting sections, via which the respective inner parts of the units are spatially connected, and that performs a function of preventing gas from flowing out of a furnace space of one of the units into that of another of the units. Examples of the gas mixing prevention means include a gate valve device that mechanically disconnects the spatial connection between one unit and another except when the substrate moves from one unit to another, a gas curtain device that disconnects the spatial connection by ejecting an inert gas, and an exhaust device through which gasses in the connecting sections and/or those areas in the units which are near the connecting sections are exhausted out of the system. In order to surely prevent gas mixing, it is preferable that a shutter and/or a gas curtain be used in combination with the exhaust device. Further, in order to transfer the substrate from one unit to another without interruption from the point of view of efficient continuous growth, and from the point of view of simplification of mechanism, it is more preferable that the exhaust device be used alone.

Flowing the raw material gas into the formation furnace inhibits reducing of the catalyst thereby adversely affecting the growth of the CNTs. Therefore, the gas mixing prevention means needs to function in such a manner that a concentration of carbon atoms in the formation furnace is preferably not more than $5 \times 10^{22}$ atoms/m$^3$, more preferably not more than $1 \times 10^{22}$ atoms/m$^3$.

When the exhaust device is used to prevent gas mixing, the each exhaust quantity Q of a plurality of exhaust sections cannot be independently determined, and need to be adjusted according to the amount of gas supplied to the whole apparatus (e.g., the flow rate of the reducing gas, the flow rate of the raw material gas, and the flow rate of a coolant gas). However, a necessary condition for gas mixing prevention to be satisfied can be represented by the following equation:

$$Q \geq 4DS/L$$

where D is a diffusion coefficient of a gas that needs to be prevented from flowing in, S is a sectional surface area of a boundary at which the gas is prevented from flowing in, and L is a length of each exhaust section (along the length of the furnace). The exhaust quantity of each exhaust section is set such that the conditional equation is satisfied and a balance between gas supply and gas exhaust in the whole apparatus is kept.

(Connecting Sections)

The connecting sections are a set of devices via which the respective furnace spaces of the units are spatially connected and which serve to prevent the substrate from being exposed to the outside air when it is transferred from one unit to another. An example of the connecting sections is a furnace or chamber capable of shielding the environment surrounding the substrate from the outside air and passing the substrate from one unit to another.

(Cooling Unit)

The cooling unit is a set of devices necessary for cooling down the substrate on which the aligned CNT aggregate has grown. The cooling unit has a function of preventing oxidation and cooling effects on the aligned CNT aggregate, the catalyst and the substrate after the growth step. Examples of the cooling unit include a cooling furnace in which an inert gas is retained, a water-cooled cooling tube disposed so as to surround an internal space of the cooling furnace in the case of a water-cooled type, and an ejection section that ejects the inert gas into the cooling furnace in the case of an air-cooled type. Further, the water-cooled type and the air-cooled type may be combined.

(Outlet Purge Section)

The outlet purge section is a set of devices for preventing the outside air from flowing into the furnace of the apparatus through a substrate outlet. The outlet purge section has a function of causing the substrate to be surrounded by a purge gas environment constituted by a purge gas. Specific examples of the outlet purge section include a furnace or chamber in which the purge gas environment of is retained, and an ejection section for ejecting the purge gas. It is preferable that the purge gas be an inert gas. In particular, in terms of safety, cost, purging properties and the like, it is preferable that the purge gas be nitrogen. When the substrate outlet is always open as in the case of the belt-conveyor type, it is preferable to use, as a purge gas ejection section, a gas curtain device that ejects the purge gas from top and bottom in the form of a shower, in order to prevent the outside air from flowing in through an outlet of the apparatus.

Firstly, the substrate on which a catalyst is formed is transferred into the apparatus by the transfer unit 3-7. Specifically, the transfer unit 3-7 is a belt-conveyor type transfer unit, and a substrate 3-11 is transferred on a mesh belt 3-7a driven by a belt driving section 3-7b such as the reducer-equipped electric motor. The substrate 3-11 is transferred to the inlet purge section 3-1 of the apparatus. In the inlet purge section 3-1, an environment surrounding the substrate 3-11 is replaced with a purge gas. Further, the inlet purge section 3-1 makes it possible to prevent the outside air from flowing into the furnace of the apparatus.

The inlet purge section 3-1 is spatially connected to the formation unit 3-2 via the connection section 3-8. The substrate 3-11 is transferred to the formation unit 3-2 through the connection section 3-8. The connection section 3-8 is provided with an exhaust section 3-3a of the gas mixing prevention means 3-3. From the exhaust section 3-3a, a mixed gas of the purge gas ejected from the inlet purge section 3-1 and a reducing gas ejected from a reducing gas ejection section 3-2b is exhausted. This makes it possible to prevent the purge gas from flowing into the formation furnace and the reducing gas from flowing into the inlet purge section.

A formation step is carried out while the substrate 3-11 is transferred in the formation unit 3-2.

The formation unit 3-2 is spatially connected to the growth unit 3-4 via the connection section 3-9. The substrate 3-11 is transferred to the growth unit 3-4 through the connection section 3-9. The connection section 3-9 is provided with an exhaust section 3-3b of the gas mixing prevention means 3-3. From the exhaust section 3-3b, a mixed gas of the reducing gas retained in the formation furnace and a raw material gas retained in the growth furnace is exhausted. This makes it possible to prevent the raw material gas from flowing into the formation furnace and the reducing gas from flowing into the growth furnace.

A growth step is carried out while the substrate 3-11 is transferred in the growth unit 3-4.

The growth unit 3-4 is spatially connected to the cooling unit 3-5 via the connection unit 3-10. The substrate 3-11 is transferred to the cooling unit 3-5 through the connection section 3-10. The connection section 3-10 is provided with an exhaust section 3-3c of the gas mixing prevention means 3-3. From the exhaust section 3-3c, a mixed gas of the raw material gas retained in the growth furnace and an inert gas retained in the cooling furnace is exhausted. This makes it possible to prevent the raw material gas from flowing into the cooling furnace and the inert gas from flowing into the growth furnace.

A cooling step is carried out while the substrate 3-11 is transferred in the cooling unit 3-5. A cooling step is a step of, after the growth step, cooling down the aligned CNT aggregate, the catalyst and the substrate in the presence of an inert gas.

The outlet purge section 3-6 is provided in the outlet of the apparatus. The outlet purge section 3-6 makes it possible to prevent the outside air from flowing into the apparatus from the outlet of the apparatus.

As described above, in a CNT production apparatus of the present invention, the substrate on which surface the catalyst is formed is successively transferred to the inlet purge section 3-1, the formation unit 3-2, the growth unit 3-4, the cooling unit 3-5 and the outlet purge section 3-6 in this order by the transfer unit 3-7. During the successive transfer, the catalyst is reduced by the reducing gas in the formation unit 3-2, the CNTs are grown on the surface of the substrate in the presence of the raw material gas in the growth unit 3-4, and the CNTs are cooled down in the cooling unit 3-5.

Examples

The following describes in detail the present invention on the basis of examples. However, the present invention is not limited to these examples. Further, these examples of the present invention were evaluated by the following methods.

(Measurement of Specific Surface Area)

The specific surface area was measured by use of a BET specific surface area measuring apparatus (HM model-1210; manufactured by MOUNTECH Co., Ltd.).

(G/D Ratio)

A G/D ratio is an intensity ratio observed by raman spectrometry of a G band which is specific to CNTs to a D band derived from defects. In the present example, a G/D ratio of CNTs located near the center of a substrate was measured by a microscopic laser raman system (Nicolet Almega XR; manufactured by Thermo Fisher Scientific K.K.).

(Surface Roughness)

A surface roughness of the present invention is an arithmetic average roughness Ra. A value of Ra was calculated under the following measurement condition by use of a laser microscope (VK-9710 manufactured by KEYENCE CORPORATION).

<Measurement Condition>

Measurement mode: surface shape
Measurement quality: high resolution
Objective lens: CF IC EPI Plan 10×
Measuring range: 1.42 mm$^2$ (1.42 mm × 1.0 mm)
Measurement pitch in a Z direction: 0.1 $\mu$m
Analysis software (VK-shaped analysis application VK-H1A1 manufactured by KEYENCE CORPORATION) has a function of measuring "surface roughness". Ra was calculated on the basis of height data calculated by the analysis software.

A substrate was placed in an apparatus for producing aligned carbon nanotube aggregates (CVD apparatus), and CVD was carried out on the substrate, that is, carbon nanotubes were produced on the substrate. Thereafter, how much the substrate on which the carbon nanotubes were produced was bent was measured. Specifically, as shown in Fig. 4, the substrate on which the carbon nanotubes were produced was placed on a reference surface in such a manner that a convex surface of the substrate faces the reference surface, and a height from the reference surface to an edge of the substrate was measured by a caliper as how much the substrate was bent.

[Example 1]

Fig. 3 shows a production apparatus used in the present example. The production apparatus included the inlet purge section 3-1, the formation unit 3-2, the gas mixing prevention unit 3-3, the growth unit 3-4, the cooling unit 3-5, the outlet purge section 3-6, the transfer unit 3-7, and the connection sections 3-8 to 3-10. The formation unit 3-2 included the formation furnace 3-2a, the reducing gas ejection section 3-2b for ejecting a reducing gas, and a heater 3-2c for heating the substrate and/or the reducing gas. The gas mixing prevention unit 3-3 included the exhaust sections 3-3a to 3-3c. The growth unit 3-4 included the growth furnace 3-4a, a raw material gas ejection section 3-4b for ejecting a raw material gas, and a heater 3-4c for heating the substrate and/or the raw material gas. The cooling unit 3-5 included the cooling furnace 3-5a, a coolant gas ejection section 3-5b for ejecting an inert gas, and a water-cooled cooling tube 3-5c. The respective furnace walls and ejection sections of the formation and growth units, the gas mixing prevention means, the mesh belt, and the connection sections were made from SUS 310 plated with aluminum.

Conditions for producing a catalyst substrate are described below. A base substrate used was Fe-Ni-Cr alloy YEF 426 (Ni 42%, Cr 6%; manufactured by Hitachi Metals, Ltd.) having a size of 90 mm × 90 mm with a thickness of 0.3 mm. A surface roughness of the base substrate was measured by use of a laser microscope, and it was found that an arithmetic average roughness of the base substrate was Ra ≒ 2.1 μm. An alumina layer (carburizing prevention layer) with a thickness of 20 nm was formed on both front and back surfaces of the base substrate by use of a sputtering apparatus. Then, an iron layer (catalyst) with a thickness of 1.0 nm was formed only on the front surface by use of the sputtering apparatus.

The catalyst substrate thus prepared was placed on the mesh belt of the production apparatus (shown in Fig. 3), and subjected to the formation, growth, and cooling steps in this order with varying speeds of transfer of the mesh belt, whereby an aligned CNT aggregate was produced. The conditions for the production apparatus were set as follows:

Inlet purge section 3-1
Purge gas: nitrogen 60,000 sccm
Formation unit 3-2

Furnace temperature: 830°C
Reducing gas: nitrogen 11,200 sccm, hydrogen 16,800 sccm
Mesh belt transfer speed: 20 mm/min

Gas mixing prevention means 3-3

Exhaust quantity of the exhaust section 3-3a: 20 sLm
Exhaust quantity of the exhaust section 3-3b: 25 sLm
Exhaust quantity of the exhaust section 3-3c: 20 sLm

Growth unit 3-4

Furnace temperature: 830°C
Raw material gas: nitrogen 16,040 sccm, ethylene 1,800 sccm, water vapor-containing nitrogen 160 sccm (relative moisture 23.3%)
Mesh belt transfer speed: 30 mm/min

Cooling unit 3-5

Cooling water temperature: 30°C
Inert gas: nitrogen 10,000 sccm
Mesh belt transfer speed: 30 mm/min

Outlet purge section 3-6
Purge gas: nitrogen 50,000 sccm

Although properties of an aligned CNT aggregate that is produced according to the present example depends on details of production conditions, the aligned CNT aggregate was produced typically with a yield of 1.8 mg/cm$^2$, and the aligned CNT aggregate typically had a G/D ratio of 8.0, a density of 0.03 g/cm$^3$, a BET specific surface area of 1,100 m$^2$/g, an average external diameter of 2.9 nm, a half width of 2 nm, a carbon purity of 99.9%, and a Herman's orientation factor of 0.7. Further, the substrate was bent by 1.5 mm.

[Example 2]

A base substrate used was Fe-Ni-Cr alloy YEF 426 (Ni 42%, Cr 6%; manufactured by Hitachi Metals, Ltd.) having a size of 90 mm × 90 mm with a thickness of 0.3 mm. A surface roughness of the base substrate was measured by use of the laser microscope, and it was found that an arithmetic average roughness of the base substrate was Ra ≒ 2.1 μm. A silicon oxide layer (carburizing prevention layer) with a thickness of 100 nm was formed on both front and back surfaces of the base substrate by use of the sputtering apparatus. Then, an alumina layer (catalyst) with a thickness of 10 nm and an iron layer (catalyst) with a thickness of 1.0 nm were formed only on one surface of the base substrate by use of the sputtering apparatus. Thereafter, the CVD was carried out on the catalyst substrate under the same condition as that in First Example, whereby carbon nanotubes were synthesized.

Although the properties of the aligned CNT aggregate that is produced according to the present example depends on the details of production conditions, the aligned CNT aggregate was produced typically with a yield of 1.8 mg/cm$^2$, and the aligned CNT aggregate typically had a G/D ratio of 8.0, a density of 0.03 g/cm$^3$, a BET specific surface area of 1,100 m$^2$/g, an average external diameter of 2.9 nm, a half width of 2 nm, a carbon purity of 99.9%, and a Herman's orientation factor of 0.7. Further, the substrate was bent by 1.5 mm.

[Example 3]

The following describes another method (Example 3) for producing a single-walled aligned CNT aggregate of the present invention. Fig. 5 shows a flowchart of a production step in accordance with the present example. Fig. 6 shows in detail a process condition.

A base substrate used was Fe-Ni-Cr alloy YEF 426 (Ni 42%, Cr 6%; manufactured by Hitachi Metals, Ltd.) having a size of 10 mm × 10 mm with a thickness of 0.3 mm. A surface roughness of the base substrate was measured by use of the laser microscope, and it was found that an arithmetic average roughness of the base substrate was Ra ≒ 2.1 μm. An Alumina layer (carburizing prevention layer) with a thickness of 100 nm was formed on both front and back surfaces of the base substrate by use of the sputtering apparatus. Then, an iron layer (catalyst) with a thickness of 1.0 nm was formed only on the front surface by use of the sputtering apparatus.

The catalyst substrate was placed in a reaction furnace of the CVD apparatus (shown in Fig. 2) which reaction furnace had a furnace temperature of 750°C and a furnace pressure of 1.02E+5. Thereafter, 100 sccm of helium and 900 sccm of hydrogen were introduced into the reaction furnace for 6 minutes. This caused reducing of the iron catalyst layer whereby the iron catalyst was stimulated to become fine particles suitable for the growth of single-walled CNTs. As a result, a plurality of nanometer-scaled iron particles were formed on the alumina layer (formation step). The iron particles were adjusted to have a density of not less than 1x1012 particles/cm$^2$ but not more than $1 \times 10^{14}$ particles/cm$^2$.

Thereafter, 850 sccm of helium, 100 sccm of ethylene (ethylene gas accounts for 10% of whole gas to be supplied), and 50 sccm of water-containing helium (relative moisture 23%) were supplied for 5 minutes into the reaction furnace adjusted to have the temperature of 750°C and the furnace pressure of 1.02E+5. This made it possible to grow the single-walled CNTs from the iron catalyst particles (growth process).

After the growth process, merely 1000 sccm of helium was supplied into the reaction furnace, so that remaining raw material gas and catalyst activation agent were eliminated from the reaction furnace (flush step). In this manner, the single-walled aligned CNT aggregate was produced.

Although the properties of the single-walled aligned CNT aggregate that is produced according to the present example depends on the details of production conditions, the single-walled aligned CNT aggregate was produced typically with a yield of 1.8 mg/cm$^2$, and the single-walled aligned CNT aggregate typically had a G/D ratio of 8.0, a density of 0.03 g/cm$^3$, a BET specific surface area of 1,200 m$^2$/g, an average external diameter of 2.5 nm, a half width of 2 nm, a carbon purity of 99.9%, and a Herman's orientation factor of 0.7. Further, the substrate was bent by 0 mm, that is, the substrate was not bent at all.

[Comparative Example 1]

A base substrate used was Fe-Ni-Cr alloy YEF 426 (Ni 42%, Cr 6%; manufactured by Hitachi Metals, Ltd.) having a size of 90 mm × 90 mm with a thickness of 0.3 mm. A surface roughness of the base substrate was measured by use of the laser microscope, and it was found that an arithmetic average roughness of the base substrate was Ra ≒ 2.1 μm. An iron layer (catalyst) with a thickness of 1.0 nm was formed only on one surface of the base substrate by use of the sputtering apparatus.

The CVD was carried out on the catalyst substrate in the same manner as in Example 1. However, a vertically aligned carbon nanotube aggregate did not grow on the catalyst substrate. Further, the substrate was greatly bent. Specifically, the substrate was bent by 10 mm.

[Comparative Example 2]

A base substrate used was Fe-Ni-Cr alloy YEF 426 (Ni 42%, Cr 6%; manufactured by Hitachi Metals, Ltd.) having a size of 90 mm × 90 mm with a thickness of 0.3 mm. A surface roughness of the base substrate was measured by use of the laser microscope, and it was found that an arithmetic average roughness of the base substrate was Ra ≒ 2.1 μm. An alumina layer (carburizing prevention layer) with a thickness of 20 nm was formed only on one surface of the base substrate by use of the sputtering apparatus.

Thereafter, an iron layer (catalyst) with a thickness of 1.0 nm was formed on the alumina layer by use of the sputtering apparatus. Thereafter, the CVD was carried out on the iron layer in the same manner as in Example 1, so that CNTs were synthesized. Although the properties of the aligned CNT aggregate that is produced according to the present example depends on the details of production conditions, the aligned CNT aggregate was produced typically with a yield of 0.5 mg/cm$^2$, and the aligned CNT aggregate typically had a G/D ratio of 8.0, a density of 0.03 g/cm$^3$, a BET specific surface area of 1,100 m$^2$/g, an average external diameter of 2.9 nm, a half width of 2 nm, a carbon purity of 99.9%, and a Herman's orientation factor of 0.7. The CNTs did not evenly grow on the substrate, and did not grow on some parts of the substrate. Therefore, production quantity of the CNTs was not great. Further, the substrate was greatly bent. Specifically, the substrate was bent by 12 mm.

[Comparative Example 3]

A base substrate used was Fe-Ni-Cr alloy YEF 426 (Ni 42%, Cr 6%; manufactured by Hitachi Metals, Ltd.) having a size of 10 mm × 10 mm with a thickness of 0.3 mm. A surface roughness of the base substrate was measured by use of the laser microscope, and it was found that an arithmetic average roughness of the base substrate was Ra ≒ 2.1 μm. An alumina layer (carburizing prevention layer) with a thickness of 100 nm was formed only on one surface of the base substrate by use of the sputtering apparatus. Thereafter, an iron layer (catalyst) with a thickness of 1.0 nm was formed on the alumina layer by use of the sputtering apparatus.

Thereafter, the CVD was carried out on the iron layer in the same manner as in Example 3. Although the properties of the aligned CNT aggregate that is produced according to the present example depends on the details of production conditions, the aligned CNT aggregate was produced typically with a yield of 1.8 mg/cm$^2$, and the aligned CNT aggregate typically had a G/D ratio of 8.0, a density of 0.03 g/cm$^3$, a BET specific surface area of 1,200 m$^2$/g, an average external diameter of 2.5 nm, a half width of 2 nm, a carbon purity of 99.9%, and a Herman's orientation factor of 0.7. Further, the substrate was bent by 2.0 mm. Namely, the base substrate having a size of 10 mm × 10 mm was not greatly bent. Therefore, the growth of CNTs was not adversely affected, and the CNTs evenly grew on the base substrate.

[Comparative Example 4]

A base substrate used was Fe-Ni-Cr alloy YEF 426 (Ni 42%, Cr 6%; manufactured by Hitachi Metals, Ltd.) having a size of 10 mm × 10 mm with a thickness of 0.3 mm. A surface roughness of the base substrate was measured by use of the laser microscope, and it was found that an arithmetic average roughness of the base substrate was Ra ≒ 2.1 μm. An alumina layer (carburizing prevention layer) with a thickness of 100 nm was formed only on one surface of the base substrate by use of the sputtering apparatus. Thereafter, an iron layer (catalyst layer) with a thickness of 1.0 nm was formed on the alumina layer by use of the sputtering apparatus.

Thereafter, the CVD was carried out on the catalyst substrate in the same manner as in Example 3 except that ethylene that was a raw material gas was supplied at a rate of 10 sccm (the ethylene gas accounts for 1% of whole gas to be supplied).

Although the properties of the aligned CNT aggregate that is produced according to the present example depends on the details of production conditions, the aligned CNT aggregate was produced typically with a yield of 0.2 mg/cm$^2$, and the aligned CNT aggregate typically had a G/D ratio of 8.0, a density of 0.03 g/cm$^3$, a BET specific surface area of 1,200 m$^2$/g, an average external diameter of 2.5 nm, a half width of 2 nm, a carbon purity of 99.9%, and a Herman's orientation factor of 0.7. Further, the substrate was not bent at all. The substrate of Comparative Example 4 was less bent than that of Comparative Example 3. However, production quantity of CNTs was greatly decreased in the present example because the rate at which the ethylene was supplied was low.

[Comparative Example 5]

A base substrate used was made from a material identical to that of the base substrate of Example 3, and had an arithmetic average roughness Ra ≒ 3.7 μm. An alumina layer (carburizing prevention layer) with a thickness of 100 nm was formed on one surface of the base substrate by use of the sputtering apparatus. Thereafter, an iron layer (catalyst metal layer) with a thickness of 1.0 nm was formed on the alumina layer by use of the sputtering apparatus. Thereafter, the CVD was carried out on the catalyst substrate in the same manner as in Example 3. However, a vertically aligned CNT aggregate did not grow on the catalyst substrate. Further, the substrate was bent by 2.0 mm.

The substrates used in Example 1, Comparative Examples 1 and 2 were halved. Thereafter, cross sections of the substrates were polished by use of polishing paper, and then soaked in a mixture solution of ethanol and nitric acid for 2 hours so as to be corroded.

Thereafter, the cross sections were observed by use of the laser microscope. Fig. 7 shows the cross section of the substrate of Example 1. Fig. 8 shows the cross section of the substrate of Comparative Example 1. Fig. 9 shows the cross section of the substrate of Comparative Example 2. As shown in these Figures, surfaces on which a carburizing prevention layer was not formed were deteriorated by carburization.

It is preferable that a substrate for producing aligned CNT aggregates in accordance with the present invention be such a metal base substrate that has both front and back surfaces on which carburizing prevention layers are formed and on at least any one of which carburizing prevention layers a catalyst is further formed. Further, it is preferable that the metal base substrate be made from an Fe-Cr alloy, an Fe-Ni alloy, or an Fe-Cr-Ni alloy.

Further, it is preferable that the metal base substrate has a thickness of not less than 0.05 mm but not more than 3 mm, and the front and back surfaces of the metal base substrate have an arithmetic average roughness Ra of not more than 3 $\mu$m. Further, it is preferable that the carburizing prevention layers mainly contain a ceramic material.

Industrial Applicability

The present invention makes it possible to efficiently produce high-quality carbon nanotubes at low cost while preventing a substrate from bending and the like. Therefore, the prevent invention is suitably applicable to fields of electronic device materials, optical element materials, conducting materials, and like materials.

Reference Signs List

1-1: substrate (substrate for producing aligned carbon nanotube aggregates)
1-1a: metal base substrate
1-1b: carburizing prevention layer
1-1c: catalyst (catalyst layer)
2-1: CVD apparatus
2-2: substrate
2-2a: catalyst layer formation surface
2-3: synthesizing furnace
2-4: heating means
2-5: gas supply tube
2-6: gas supply tube
2-7: gas discharge tube
2-8: collecting and dividing tube
2-9: raw material gas supply section
2-10: catalyst activation material supply section
2-11: atmospheric gas supply section
2-12: reducing gas supply section
2-13: substrate holder
2-14: shower head
3-1: inlet purge section
3-2: formation unit
3-2a: formation furnace
3-2b: reducing gas ejection section
3-2c: heater
3-3: gas mixing prevention means
3-3a: exhaust section
3-3b: exhaust section
3-3c: exhaust section
3-4: growth unit
3-4a: growth furnace

3-4b: raw material gas ejection section
3-4c: heater
3-5: cooling unit
3-5a: cooling furnace
3-5b: coolant gas ejection section
3-5c: water-cooled cooling tube
3-6: outlet purge section
3-7: transfer unit
3-7a: mesh belt
3-7b: belt driving section
3-8: connection section
3-9: connection section
3-10: connection section
3-11: catalyst substrate

## Claims

1. A substrate for producing aligned carbon nanotube aggregates on a surface thereof, the substrate for producing aligned carbon nanotube aggregates comprising:

   a metal base substrate made from an Fe-Cr alloy, an Fe-Ni alloy, or an Fe-Cr-Ni alloy; and
   carburizing prevention layers formed on both front and back surfaces of the metal base substrate, respectively.

2. The substrate as set forth in claim 1 for producing aligned carbon nanotube aggregates comprising:
   a catalyst on at least any one of the carburizing prevention layers formed on the both front and back surfaces of the metal base substrate, respectively.

3. The substrate as set forth in claim 1 or 2 for producing aligned carbon nanotube aggregates wherein
   the metal base substrate has a thickness of not less than 0.05 mm but not more than 3 mm, and
   the front and back surfaces of the metal base substrate have an arithmetic average roughness Ra of not more than 3 $\mu$m.

4. The substrate as set forth in any one of claims 1 to 3 for producing aligned carbon nanotube aggregates wherein
   the carburizing prevention layers are made from a ceramic material.

5. A method for producing aligned carbon nanotube aggregates on a surface of a substrate as set forth in any one of claims 1 to 4 for producing aligned carbon nanotube aggregates,
   the method comprising the steps of:

   causing the substrate for producing aligned carbon nanotube aggregates to be surrounded by a raw material gas environment constituted by a raw material gas;
   heating at least either the substrate for producing aligned carbon nanotube aggregates or the raw material gas; and
   producing, by means of chemical vapor deposition, the aligned carbon nanotube aggregates on the surface of the substrate for producing aligned carbon nanotube aggregates.

## Patentansprüche

1. Substrat zur Herstellung ausgerichteter Kohlenstoffnanoröhrchenaggregate auf einer Fläche hiervon,
   wobei das Substrat zur Herstellung ausgerichteter Kohlenstoffnanoröhrchenaggregate umfasst:

   ein Substrat auf Metallbasis aus einer Fe-Cr Legierung, einer Fe-Ni Legierung, oder einer Fe-Cr-Ni Legierung; und
   Schichten zum Schutz vor Aufkohlung gebildet jeweils auf beiden Vorder- und Rückflächen des Substrats auf Metallbasis.

**2.** Das Substrat gemäß Anspruch 1 zur Herstellung ausgerichteter Kohlenstoffnanoröhrchenaggregate umfassend: einen Katalysator auf mindestens irgend einer der Schichten zum Schutz vor Aufkohlung gebildet jeweils auf beiden Vorder- und Rückflächen des Substrats auf Metallbasis.

**3.** Das Substrat gemäß Anspruch 1 oder 2 zur Herstellung ausgerichteter Kohlenstoffnanoröhrchenaggregate wobei das Substrat auf Metallbasis eine Dicke von nicht weniger als 0,05 mm aber nicht mehr als 3 mm hat, und die Vorder- und Rückflächen des Substrats auf Metallbasis eine arithmetisch mittlere Rauheit Ra von nicht mehr als 3 $\mu$m haben.

**4.** Das Substrat gemäß irgend einem der Ansprüche 1 bis 3 zur Herstellung ausgerichteter Kohlenstoffnanoröhrchenaggregate wobei die Schichten zum Schutz vor Aufkohlung aus einem keramischen Material sind.

**5.** Ein Verfahren zur Herstellung ausgerichteter Kohlenstoffnanoröhrchenaggregate auf einer Fläche eines Substrats gemäß irgend einem der Ansprüche 1 bis 4 zur Herstellung ausgerichteter Kohlenstoffnanoröhrchenaggregate, wobei das Verfahren die Schritte umfasst aus:

Veranlassen, dass das Substrat zur Herstellung ausgerichteter Kohlenstoffnanoröhrchenaggregate umgeben ist von einer Rohmaterialgas-Umgebung bestehend aus einem Rohmaterialgas; Erhitzen von mindestens entweder dem Substrat zur Herstellung ausgerichteter Kohlenstoffnanoröhrchenaggregate oder dem Rohmaterialgas; und Herstellen, mittels chemischer Gasphasenabscheidung, der ausgerichteten Kohlenstoffnanoröhrchenaggregate auf der Fläche des Substrats zur Herstellung ausgerichteter Kohlenstoffnanoröhrchenaggregate.

## Revendications

**1.** Substrat pour produire des agrégats de nanotubes de carbone alignés sur une surface de celui-ci, le substrat pour produire des agrégats de nanotubes de carbone alignés comprenant :

un substrat de base métallique fait à partir d'un alliage de Fe-Cr, d'un alliage de Fe-Ni, ou d'un alliage de Fe-Cr-Ni ; et des couches de prévention de carburation formées sur les surfaces tant antérieure que postérieure du substrat de base métallique, respectivement.

**2.** Substrat selon la revendication 1 pour produire des agrégats de nanotubes de carbone alignés comprenant : un catalyseur sur au moins l'une quelconque des couches de prévention de carburation formées sur les surfaces tant antérieure que postérieure du substrat de base métallique, respectivement.

**3.** Substrat selon la revendication 1 ou 2 pour produire des agrégats de nanotubes de carbone alignés, dans lequel le substrat de base métallique a une épaisseur non inférieure à 0,05 mm mais non supérieure à 3 mm, et les surfaces antérieure et postérieure du substrat de base métallique ont une rugosité moyenne arithmétique Ra non supérieure à 3 $\mu$m.

**4.** Substrat selon l'une quelconque des revendications 1 à 3 pour produire des agrégats de nanotubes de carbone alignés, dans lequel les couches de prévention de carburation sont faites à partir d'un matériau céramique.

**5.** Procédé pour produire des agrégats de nanotubes de carbone alignés sur une surface d'un substrat tel que défini dans l'une quelconque des revendications 1 à 4 pour produire des agrégats de nanotubes de carbone alignés, le procédé comprenant les étapes de :

faire en sorte que le substrat pour produire des agrégats de nanotubes de carbone alignés soit entouré par un environnement de gaz matière première constitué d'un gaz matière première ; chauffer au moins soit le substrat pour produire des agrégats de nanotubes de carbone alignés soit le gaz matière première ; et produire, au moyen d'un dépôt chimique en phase vapeur, les agrégats de nanotubes de carbone alignés sur la surface du substrat pour produire des agrégats de nanotubes de carbone alignés.

F I G. 1

F I G. 2

RAW MATERIAL GAS

CATALYST ACTIVATION MATERIAL

ATOMOSPHERIC GAS

REDUCING GAS

2—9

2—10

2—11

2—12

EP 2 397 440 B1

FIG. 3

F I G. 4

REFERENCE
SURFACE

SUBSTRATE

HOW MUCH SUBSTRATE IS BENT

F I G. 5

SYNTHESIS OF
CARBON NANOTUBE

TRANSFER SUBSTRATE INTO
HEAT-GENERATING SYNTHESIZING FURNACE

Formation
(T1)

Growth
(T3)

Flush

KEEPING FURNACE AT
CONSTANT TEMPERATURE OF 750°C

TAKING OUT SUBSTRATE FROM
HEAT-GENERATING SYNTHESIZING FURNACE

F I G. 6

| | Formation (T1) | Growth (T3) | Flush |
|---|---|---|---|
| Time (min) | 6 | 5 | 2 |
| Pressure (Pa) | 1.02E+5 | 1.02E+5 | 1.02E+5 |
| Furnace Temp. (°C) | 750 | 750 | 750 |
| Total flow (sccm) | 1000 | 1000 | 1000 |
| He (sccm) | 100 | 850 | 1000 |
| $H_2$ (sccm) | 900 | 0 | 0 |
| CATALYST ACTIVATION MATERIAL CONTAINING GAS (sccm) | 0 | 50 | 0 |
| $C_2H_4$ (sccm) | 0 | 100 | 0 |

| Furnace Temp. | 750°C RT | KEEPING FURNACE AT CONSTANT TEMPERATURE | | |
|---|---|---|---|---|
| Gas | Total flow | | | |
| | He | | | |
| | H2 | | | |
| | CATALYST ACTIVATION MATERIAL CONTAINING GAS (H2O) | | | |
| | $C_2H_4$ | | | |

EP 2 397 440 B1

FIG.7

SUBSTRATE

PRESENCE OF CARBURIZING
PREVENTION LAYER

PRESENCE OF CARBURIZING
PREVENTION LAYER

F I G. 8

SUBSTRATE
ABSENCE OF CARBURIZING
PREVENTION LAYER

ABSENCE OF CARBURIZING
PREVENTION LAYER

F I G. 9

SUBSTRATE

ABSENCE OF CARBURIZING
PREVENTION LAYER

PRESENCE OF CARBURIZING
PREVENTION LAYER

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003171108 A
- WO 2006011655 A1
- US 20080131655 A1
- US 20050092464 A1

**Non-patent literature cited in the description**

- **HYOUMEN KAGAKU.** *Journal of The Surface Science Society of Japan,* 2007, vol. 28 (2), 104-110
- *Nature Materials,* 2006, vol. 5, 987-994